# EUROPÄISCHE PATENTSCHRIFT

(11) **EP 3 240 375 B1**
(45) Veröffentlichungstag und Bekanntmachung des Hinweises auf die Patenterteilung: **07.09.2022**
(21) Anmeldenummer: 17401043.9
(22) Anmeldetag: 20.04.2017
(51) Int. Cl.: H05K 3/34, H05K 5/00, H05K 7/12, H05K 3/30, H01G 2/06

(54) **ELEKTRONIKMODUL MIT EINEM EIN OPTIMIERTES DESIGN AUFWEISENDEN HALTEELEMENT ZUR VERBESSERTEN FLÄCHENNUTZUNG DER LEITERPLATTE**
ELECTRONIC MODULE WITH A HOLDER ELEMENT COMPRISING AN OPTIMIZED DESIGN FOR IMPROVED THE SURFACE UTILISATION OF THE PRINTED CIRCUIT BOARD
MODULE ÉLECTRONIQUE AYANT UN ÉLÉMENT DE RETENUE AYANT UNE CONCEPTION OPTIMISÉE DESTINÉ À L'UTILISATION AMÉLIORÉE DE LA SURFACE DU CIRCUIT IMPRIMÉ

(30) Priorität: 25.04.2016 DE 102016206930
(43) Veröffentlichungstag der Anmeldung: 01.11.2017
(73) Patentinhaber: Schaeffler Technologies AG & Co. KG, 91074 Herzogenaurach (DE)
(72) Erfinder: Botiov, Julian, 77815 Bühl (DE)

(56) Entgegenhaltungen:
- EP-A1- 2 727 185
- DE-A1- 10 062 962
- DE-C1- 19 814 156
- JP-A- 2006 148 011
- US-A1- 2008 291 653
- US-A1- 2011 038 133

## Beschreibung

Die Erfindung betrifft ein Elektronikmodul (auch als Steuereinheit / Steuergerät bezeichnet) für einen in einem Kraftfahrzeug verwendbaren Aktor, insbesondere einem Kupplungs- und/oder Getriebeaktor, mit einer Leiterplatte (auch als PCB bezeichnet) sowie zumindest einem auf der Leiterplatte angeordneten elektronischen Bauteil, wobei das elektronische Bauteil mittels eines Halteelementes so beabstandet zu einer Oberfläche der Leiterplatte gehalten ist, dass ein Aufnahmeraum zwischen dem elektronischen Bauteil und der Leiterplatte ausgebildet ist. Besagte Elektronikmodule werden insbesondere als integrierte lokale Steuereinheiten in entsprechenden Antriebsmodulen einer Aktorik / eines Aktors eines Kraftfahrzeuges verwendet. Die Erfindung betrifft folglich auch einen Aktor zum Betätigen einer Kupplung und/oder eines Getriebes eines Kraftfahrzeuges, mit einem solchen Elektronikmodul.

Prinzipiell sind Elektronikmodule zur Erfassung von Betriebsdaten einer Antriebseinheit eines Aktors und/oder zur Steuerung der Antriebseinheit bereits bekannt. Die WO 2011/050767 A1 offenbart einen Hydrostat-Aktor mit einem Geberzylinder enthaltend ein Gehäuse und eine in dem Gehäuse axial verlagerbaren, eine mit Druckmittel befüllte Druckkammer mit druckbeaufschlagenden Kolben, mit einem einen Drehantrieb in eine Axialbewegung wandelnden Planetenwälzgetriebe, mit einer Hülse, einer Getriebespindel und zwischen diesen abwälzenden Planetenwälzkörpern sowie mit einem das Planetenwälzgetriebe antreibenden Elektromotor mit einem gehäusefest verbundenen Stator und einem gegenüber diesem verdrehbaren Rotor, wobei die Druckkammer ringförmig ausgebildet ist und das Planetenwälzgetriebe radial innerhalb der Druckkammer angeordnet ist. Auf einer Platine einer Vorortelektronik ist in diesem Zusammenhang zumindest ein Sensor zur Erfassung von Betriebsdaten des Hydrostat-Aktors angeordnet.

Bei der Verwendung relativ großvolumiger, schwerer elektronischer Bauteile, wie Kondensatorbauteilen, auf Leiterplatten wird eine liegende, etwa eine parallele Ausrichtung einer Längsachse des elektronischen Bauteils zur Leiterplatte, insbesondere dann einer stehenden Ausrichtung vorgezogen, wenn eine möglichst robuste, dauerfeste Anbringung des elektronischen Bauteils an der Leiterplatte gefordert ist. Die elektronischen Bauteile sind hierbei insbesondere gegenüber im Betrieb auftretenden Vibrationen abzustützen. Um das elektronische Bauteil ausreichend fest an der Leiterplatte zu befestigen, werden diese zumeist unmittelbar auf die Oberfläche der Leiterplatte aufgeklebt. Diese Befestigungsmethode hat jedoch wiederum den Nachteil, dass ein relativ großer Flächenbereich der Leiterplatte, auf dem das Bauteil aufgeklebt wird, nicht genutzt werden kann.

Alternative Befestigungsmöglichkeiten, um Bauteile mittels Abstandselementen auf der Leiterplatte von derselben zu beabstanden sind bekannt, z.B. aus der DE 100 62 962 A1, US 2008/291653 A1, US 2011/038133 A1, JP 2006 148011 A, DE 198 14 156 C1 oder der WO 2013/002684 A1. Auch hier kann es zu Problemen bei der Wärmeabfuhr des elektronischen Bauteils kommen.

Es ist daher die Aufgabe der vorliegenden Erfindung, die aus dem Stand der Technik bekannten Nachteile zu beheben und eine Leiterplatte für ein Elektronikmodul zur Verfügung zu stellen, bei der die Bauraumausnutzung gesteigert werden soll.

Dies wird erfindungsgemäß mittels der Merkmalskombination, wie sie im Anspruch 1 beansprucht ist, gelöst. Das elektronische Bauteil ist mittels eines Halteelementes so beabstandet zu einer Oberfläche der Leiterplatte gehalten ist, dass ein Aufnahmeraum zwischen dem elektronischen Bauteil und der Leiterplatte ausgebildet ist. Das Haltelement dient somit als Abstandshalter, der abschnittsweise, nämlich im Bereich des Aufnahmeraums, so ausgeformt, etwa ausgespart, ist, dass zwischen der Leiterplatte und dem elektronischen Bauteil vorgehalten ist.

Durch das beabstandete Anbringen des elektronischen Bauteils zur Leiterplatte mittels des Halteelementes wird die nutzbare Oberfläche der Leiterplatte deutlich erhöht. Insbesondere können durch dieses Halteelement nun zusätzliche Bauteile, etwa flache Chips (wie z.B. Mikrokontroller, Sensoren etc.) oder passive SMD Bauteile unterhalb des elektronischen Bauteils auf der Leiterplatte, d.h. im Aufnahmeraum, vorgesehen werden.

Weitere vorteilhafte Ausführungsformen sind in den Unteransprüchen beansprucht und nachfolgend näher erläutert.

Weiterhin ist es vorteilhaft, wenn das elektronische Bauteil eine längliche Form / Außenform, vorzugsweise eine sich zylindrisch erstreckende Form / Außenform, aufweist und/oder liegend zur Leiterplatte angebracht ist. Unter liegend ist hierbei jene Position zu verstehen, die durch einen zwischen seiner Längsachse des elektronischen Bauteils und der Oberfläche / einer in der Oberfläche liegenden Bezugsebene der Leiterplatte eingeschlossenen Winkel definiert ist, der zwischen (einschließlich) 0° (parallel) und 45° beträgt. Besonders bevorzugt beträgt dieser Winkel 0°, d.h. ist das elektronische Bauteil mit seiner Längsachse parallel zu der Oberfläche / Bezugsebene in der Oberfläche der Leiterplatte ausgerichtet. Durch diese liegende Anordnung wird insbesondere die Vibrationsbelastung während des Betriebes des Elektronikmoduls in einem Kraftfahrzeug deutlich reduziert.

Ist das elektronische Bauteil, wie erfindungsgemäß vorgesehen als Elektrolytkondensator ausgestaltet, ist die erfindungsgemäße Umsetzung besonders effizient wirkend.

Ist das elektronische Bauteil formschlüssig an dem Halteelement angebracht, ist eine besonders rasche Fixierung des Bauteils an der Leiterplatte möglich.

In diesem Zusammenhang ist es weiterhin vorteilhaft, wenn das elektronische Bauteil über an dem Halteelement angebrachte / ausgebildete vorspannbare Haltenasen (auch als Clips-Vorsprünge / Schnappnasen bezeichnet) gehalten ist. Durch die Vorspannung ist das elektronische Bauteil im befestigten Zustand stabil gehalten.

Auch ist es zweckmäßig, wenn das elektronische Bauteil spielfrei in dem Halteelement gehalten / eingespannt ist. Dadurch ist das elektronische Bauteil noch stabiler gegenüber Vibrationsbelastungen fixiert.

Von Vorteil ist es zudem, wenn das Halteelement eine, vorzugsweise kastenförmige, etwa polygonförmige, weiter bevorzugt rechteckförmige, Rahmenstruktur aufweist, die einen Fensterbereich (auch als Durchgangsöffnung bezeichnet) einschließt, innerhalb der das elektronische Bauteil zumindest teilweise angeordnet ist. Dadurch kann ein besonders großer Bereich der Leiterplatte hin zu dem elektronischen Bauteil ausgenutzt werden.

In diesem Zusammenhang ist es weiterhin zweckmäßig, wenn das Halteelement zumindest einen Stützfuß, vorzugweise mehrere, etwa drei oder vier Stützfüße aufweist, mit dem / denen es in der Leiterplatte verankert ist. Durch die Ausbildung solcher Stützfüße ist eine besonders große Fläche der Leiterplatte im Betrieb ausnutzbar.

Weiter bevorzugt sind diese Stützfüße direkter Bestandteil der Rahmenstruktur, d.h. stoffeinteilig mit der Rahmenstruktur verbunden. Dadurch wird der Aufbau des Halteelementes weiter vereinfacht.

Die Stützfüße sind vorteilhafterweise mittels mehrerer Befestigungselemente, etwa mittels Pins / Steckbolzen oder Schnappvorsprüngen in der Leiterplatte verankert / befestigt. Dadurch lässt sich die Vibrationsbelastung auf das elektronische Bauteil im Betrieb weiter verringern.

Desweiteren ist es erfindungsgemäß vorgesehen, dass das elektronische Bauteil über eine wärmeleitende Klebeverbindung mit einem Gehäuse des Elektronikmoduls verbunden ist. Dadurch wird die Abfuhr überschüssiger Wärme aus dem elektronischen Bauteil verbessert.

Zudem ist es vorteilhaft, wenn das Halteelement aus einem Kunststoffmaterial, vorzugsweise einem spritzgießtechnisch verarbeitbaren Kunststoffmaterial, ausgeformt ist, d.h. weiter bevorzugt als ein spritzgusstechnisch hergestelltes Bauteil ausgebildet ist. Dadurch lässt sich das Halteelement besonders effizient fertigen.

Die Erfindung betrifft desweiteren einen Aktor zum Betätigen einer Kupplung und/oder eines Getriebes, d.h. einen Kupplungs- und/oder Getriebeaktor, eines Kraftfahrzeuges, wie eines Pkws, Lkws, Busses oder landwirtschaftlichen Nutzfahrzeuges, mit einem Elektronikmodul nach zumindest einem der zuvor bezeichneten Ausführungen. Dadurch ist auch ein Aktor gesamtheitlich besonders langlebig ausgestaltet.

Auch wird ein Verfahren zum Zusammenbau eines Elektronikmoduls für einen Aktor, mit zumindest folgenden Schritten offenbart:
a) Befestigen eines Halteelementes auf einer Leiterplatte, und
b) Befestigen eines elektronischen Bauteils, vorzugsweise eines Elektrolytkondensators, in einer liegenden Ausrichtung an dem Halteelement, derart, dass ein Aufnahmeraum zwischen einer Oberfläche der Leiterplatte und einer der Leiterplatte zugewandten Seite des elektronischen Bauteils ausgestaltet wird.
Dadurch ist auch ein Montageverfahren des Elektronikmoduls auf besonders effiziente Weise umgesetzt.

In anderen Worten ausgedrückt, ist somit ein Befestigungselement (Halteelement) für elektrolytische Kondensatoren umgesetzt, um einen zusätzlichen Bauraum unterhalb des Kondensators zu erreichen. Der Elektrolytkondensator ist aus Stabilitätsgründen vorzugsweise parallel zur PCB (Leiterplatte) angeordnet. Das Befestigungselement kann mit einer Steckverbindung mit der PCB und/oder vorgespannten Clips zum Halten des Kondensators gegen Vibrationen in Position gebracht werden. Das Befestigungselement weist einen offenen Boden auf, der parallel zu der PCB verläuft, jedoch zur PCB beabstandet ist. Auf diese Weise kann die zusätzliche Fläche unterhalb des Kondensators effektiv genutzt werden. Zum besseren Kühlen des Elektrolytkondensators weist dieser einen in axialer Richtung gesehenen rückwärtigen Bereich auf, der mit einer Wärmesenke ausgeführt ist. Die Wärmesenke ist über einen Wärmekleber weiter mit dem Gehäuse des Elektronikmoduls verbunden.

Desweiteren ist es alternativ auch möglich, dass die Befestigungsclips Hinterschnitte aufweisen.

Die Erfindung wird nun nachfolgend anhand von Figuren näher erläutert.

Es zeigen:
- Fig. 1: eine perspektivische Darstellung eines geschnitten dargestellten, erfindungs-gemäßen Elektronikmoduls nach einem bevorzugten Ausführungsbeispiel, wo-bei die Schnittebene derart gewählt ist, dass die Anbringung eines elektroni-schen Bauteils mittels eines Halteelementes an einer Leiterplatte gut zu erken-nen ist,
- Fig. 2: eine perspektivische Darstellung eines Teils des in dem Elektronikmodul nach Fig. 1 eingesetzten Zusammenbaus aus der Leiterplatte und dem elektroni-schen Bauteil, wobei die Anbringung des elektronischen Bauteils mittels des Halteelementes gut zu erkennen ist,
- Fig. 3: eine perspektivische Darstellung des Zusammenbaus aus Leiterplatte und elektronischem Bauteil nach Fig. 2, wobei der Zusammenbau derart geschnit-ten ist, dass das elektronische Bauteil quer zu seiner Längsachse geschnitten ist, sodass die beabstandete Haltung des elektronischen Bauteils ersichtlich ist,
- Fig. 4: eine Querschnittsdarstellung des in Fig. 3 geschnitten abgebildeten Zusam-menbaus aus Leiterplatte und elektronischem Bauteil,
- Fig. 5: eine perspektivische Darstellung einer im Zusammenbau der Leiterplatte ab-gewandten Oberseite eines Halteelementes, wie es in den Fign. 1 bis 4 ein-gesetzt ist, zur Befestigung des elektronischen Bauteils,
- Fig. 6: eine perspektivische Darstellung des Halteelementes nach Fig. 5 von seiner Unterseite, an der Befestigungselemente zur Verankerung in der Leiterplatte gut erkennbar sind, und
- Fig. 7: eine Querschnittsdarstellung des Halteelementes nach den Fign. 5 und 6, so-dass besonders gut der Querschnitt der Haltenasen sowie ein das elektroni-sche Bauteil hin zur Leiterplatte abstützender Haltesteg veranschaulicht sind.

Die Figuren sind lediglich schematischer Natur und dienen ausschließlich dem Verständnis der Erfindung. Die gleichen Elemente sind mit denselben Bezugszeichen versehen.

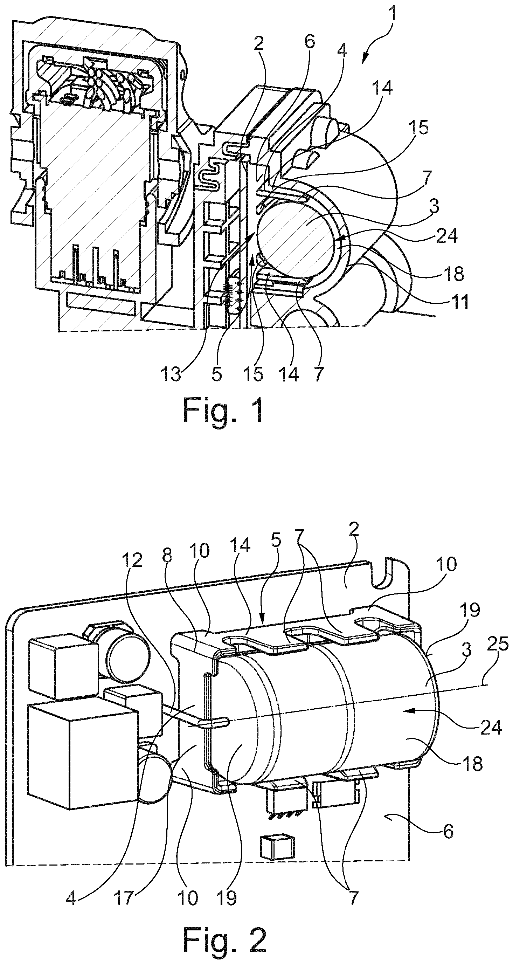

In Fig. 1 ist ein erfindungsgemäßes Elektronikmodul 1 nach einem bevorzugten Ausführungsbeispiel dargestellt. Das Elektronikmodul 1 ist als eine Steuereinheit / ein Steuergerät eines Aktors, nämlich eines Kupplungs- und/oder Getriebeaktors, ausgebildet. Das Elektronikmodul 1 ist folglich im Betrieb mit einer Antriebseinheit des Aktors elektrisch verbunden. Das Elektronikmodul 1 weist vorzugsweise hier der Übersichtlichkeit nicht dargestellte Mittel zum Antrieb des Aktors und/oder zum Bestromen einer Sensoreinrichtung zur Erfassung einer Stellung (Drehstellung) eines Stellelementes (Rotors und/oder Spindelwelle) des Aktors auf. Das Elektronikmodul 1 ist somit im Betrieb als eine im Aktor integrierte lokale Steuereinheit ausgebildet.

Das Elektronikmodul 1 weist auf typische Weise ein Gehäuse 11 auf, in dem eine Leiterplatte 2 aufgenommen ist. Diese Leiterplatte 2 in Form eines printed circuit boards / einer PCB weist mehrere elektronische Bauteile sowie Leiterbahnen auf, um eine entsprechende Schaltstruktur auszubilden. Unter anderem ist auf der Leiterplatte 2 ein elektronisches Bauteil 3 befestigt. Dieses elektronische Bauteil 3 ist als Kondensatorbauteil in Form eines Elektrolytkondensators ausgestaltet. Das elektronische Bauteil 3 ist daher nachfolgend auch als Kondensatorbauteil 3 bezeichnet. Das Kondensatorbauteil 3 weist eine zylindrische Außenform auf. Das Kondensatorbauteil 3 ist liegend auf der Leiterplatte 2 angeordnet, d.h. mit seiner Längsachse 25 im Wesentlichen parallel zu einer sich in einer gedachten Bezugsebene erstreckenden / ebenen Oberfläche 6 der Leiterplatte 2 ausgerichtet.

Die Anordnung des Kondensatorbauteils 3 ist auch besonders gut in Fig. 2 gesamtheitlich zu erkennen. Eine in das Kondensatorbauteil 3 einmündende Verbindungsleitung 12 ist auf typische Weise elektrisch mit weiteren elektronischen Bauteilen weiter verbunden. Da das Kondensatorbauteil 3 eine im Wesentlichen runde, nämlich kreisrunde Querschnittsform aufweist, ist die Verbindungsleitung 12 in einem mittigen / zentralen Bereich einer Stirnseite 19 des Kondensatorbauteils 3 angeschlossen. Eine weitere der Übersichtlichkeit nicht dargestellte Verbindungsleitung 12 ist an einer anderen Stirnseite des Kondensatorbauteils 3 auf gleiche Weise angeschlossen. Diese Bauform und beidseitige axiale Kathode/ Anode-Anordnung sind sehr häufig bei bekannten Elektrolytenkondensator-Herstellern und hat insbesondere einen deutlichen kommerziellen Vorteil vor anderen konventionellen Bauformen und Anordnungen in puncto der Anschlüsse. Diese Bauform ist wegen der ihr eigenen niedrigen Kosten bevorzugt.

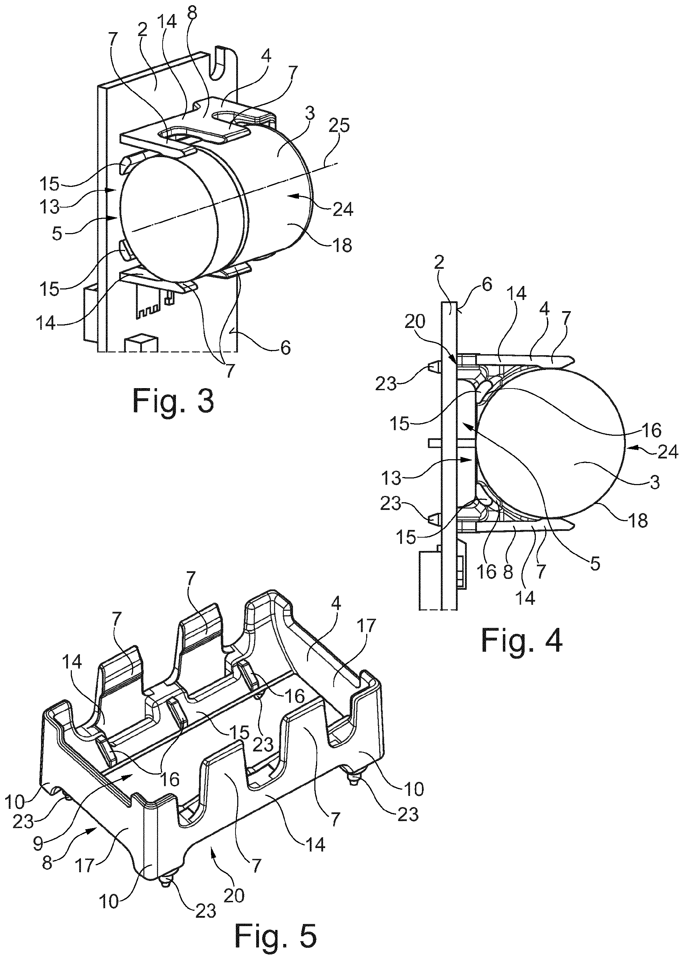

Erfindungsgemäß ist das Kondensatorbauteil 3 nicht direkt, unter Kontakt mit der Leiterplatte 2 / der Oberfläche 6 der Leiterplatte 2 fixiert, sondern mittels eines Halteelementes 4 beabstandet zu der Oberfläche 6 der Leiterplatte 2 befestigt. Diese beabstandete Stellung des Kondensatorbauteils 3 in einem zusammengebauten Zustand des Zusammenbaus aus Leiterplatte 2, Halteelement 4 und Kondensatorbauteil 3 ist auch besonders gut in den Fign. 3 und 4 erkennbar. Das Kondensatorbauteil 3 ist mittels des Halteelementes 4 derart beabstandet zu der Oberfläche 6 gehalten, dass sich ein Aufnahmeraum 5 zwischen der ebenen Oberfläche 6 und dem Kondensatorbauteil 3, d.h. einer Unterseite 13 des Kondensatorbauteils 3, die der Oberfläche 6 zugewandt ist, ausbildet. In diesem Aufnahmeraum 5 sind weitere, hier der Übersichtlichkeit halber nicht dargestellte, elektronische Bauteile platziert.

Das Halteelement 4 ist in seiner Ausbildung in Fig. 5 gut zu erkennen. Das Halteelement 4 ist mit einem Fensterbereich 9 versehen, der eine Durchgangsöffnung bildet. Dieser Fensterbereich 9 ist durch eine kastenförmige / rechteckförmige Rahmenstruktur 8 des Halteelementes 4 eingeschlossen. Das Halteelement 4 weist im Wesentlichen vier Seiten auf, die senkrecht bzw. parallel, unter Ausbildung eines Rechteckes, zueinander verlaufen. Zwei sich gegenüberliegende Längsseiten 14 des Halteelementes 4 weisen mehrere, nämlich jeweils zwei Haltenasen 7 auf. Die Haltenasen 7 bilden Schnappnasen / Clips-Vorsprünge aus, die elastisch verformbar sind und im befestigten Zustand federelastisch an die Außenseite / Mantelfläche 18 des Kondensatorbauteils 3 angedrückt sind. Insbesondere beschränken diese Haltenasen 7 die Bewegung des Kondensatorbauteils 3 weg von der Leiterplatte 2. Hin zu der Leiterplatte 2 ist das Kondensatorbauteil 3 über zwei Haltestege 15 abgestützt. Jede Längsseite 14 bildet dabei über ihre gesamte Länge hinweg einen Haltesteg 15 aus. Die Haltestege 15 erstrecken sich somit, wie bereits die Längsseiten 14, parallel zueinander. Diese Haltestege 15 definieren eine Auflage des Kondensatorbauteils 3 zur Leiterplatte 2 hin. An jedem Haltesteg 15 sind mehrere Auflagevorsprünge 16 vorgesehen. Jeder Haltesteg 15 weist drei Auflagevorsprünge 16 auf. Senkrecht zu den Längsseiten 14 sind zwei Querseiten 17 gegenüberliegend angeordnet, die die Längsseiten 14 miteinander verbinden.

Wie wiederum in Fig. 4 erkennbar, ist somit das Kondensatorbauteil 3 im Betrieb durch die elastische Vorspannung der Haltenasen 7 zwischen den Auflagevorsprüngen 16 / den Haltestegen 15 und den Haltenasen 7 eingespannt. Dadurch ist insbesondere die Mantelfläche 18 des Kondensatorbauteils 3 formschlüssig umgriffen. Das Kondensatorbauteil 3 ist innerhalb der Rahmenstruktur 8 beabstandet zur Leiterplatte angeordnet. Zur Abstützung der Stirnseiten 19 des Kondensatorbauteils 3 dienen wiederum die Querseiten 17.

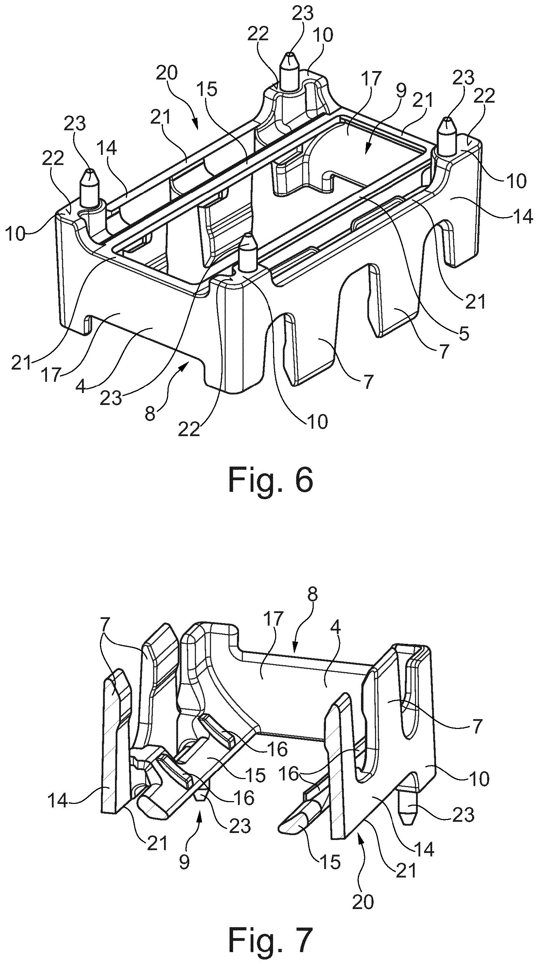

In Fig. 6 ist dargestellt, dass das Halteelement 4 an seinen Eckenbereichen, d.h. an seinen Übergangsbereichen zwischen den Längs- und Querseiten 14 und 17, jeweils einen Stützfuß 10 aufweist. Somit sind insgesamt vier Stützfüße 10 an dem Halteelement 4 angeordnet. Die Stützfüße 10 sind an einer Unterseite 20 des Halteelementes 4 angeordnet und erstrecken sich von den Unterkanten 21 der Längsseiten 14 und Querseiten 17 bzw. des Haltesteges 15 weg. Dadurch bilden die Stützfüße 10 gesamtheitlich eine Auflageebene 22 aus, die im befestigten Zustand parallel zur Oberfläche 6, nämlich flächig direkt auf der Oberfläche 6, aufliegt. Des Weiteren sind die Unterkanten 21 beabstandet zur Leiterplatte 2 angeordnet. Dadurch sind die Längs- und Querseiten 14 und 15 teilweise ebenfalls beabstandet zu der Leiterplatte 2 angeordnet, sodass der Aufnahmeraum 5 wiederum durch diese dadurch zusätzlich erzeugten Hohlräume erweitert ist.

Zur Befestigung des Halteelementes 4 bzw. der Stützfüße 10 ist in jedem der Stützfüße 10 ein Befestigungselement 23 eingesetzt. Jedes dieser Befestigungselemente 23 ist vorzugsweise als ein Stecker ausgebildet, der dann formschlüssig in einer Aufnahmebohrung / einem Aufnahmeloch der Leiterplatte 2 eingeschoben ist / eingerastet ist. Somit ist das Halteelement 4 über eine Steckverbindung mit der Leiterplatte 2 verbunden.

Wie hierbei auch besonders gut in Fig. 7 erkennbar, ist das Halteelement 4 gesamtheitlich vorzugsweise aus einem Kunststoffmaterial (etwa einem Dielektrikum) gefertigt. Das Halteelement 4 ist mittels eines Spritzgussverfahrens hergestellt. Die Längsseiten 14 samt Haltestegen 15, die Querseiten 17 sowie die Stützfüße 10 sind folglich allesamt miteinander stoffeinteilig ausgebildet. Die Befestigungselemente 23 können wiederum ebenfalls stoffeinteilig mit den Stützfüßen 10 ausgestaltet sein, können alternativ jedoch auch als separate Bauteile gefertigt sein.

Zurückkommend auf Fig. 1 sei auch darauf hingewiesen, dass das Kondensatorbauteil 3 im vollständig zusammengebauten Zustand des Elektronikmoduls 1 zusätzlich mittels einer der Übersichtlichkeit halber nicht weiter dargestellten wärmeleitfähigen Klebeverbindung an dem Gehäuse 11 befestigt / fixiert ist. Hierfür ist vorzugsweise eine Klebewulst auf einer der Leiterplatte 2 abgewandten Oberseite 24 des Kondensatorbauteils 3 angeordnet, die das Kondensatorbauteil 3 sowie das Gehäuse 11 adhäsiv miteinander verbindet. Vorzugsweise ist diese Klebeverbindung dann in einer Wärmesenke in der Mantelfläche 18 des Kondensatorbauteils 3 angebracht.

Bei einem Zusammenbau des Elektronikmoduls 1 wird zunächst das Halteelement 4 auf die Leiterplatte 2 aufgebracht. Hierfür wird das Halteelement 4 mit seinen Befestigungselementen 3 in Befestigungsmittelaufnahmelöchern / Durchgangslöchern in der Leiterplatte 2 eingerastet und somit formschlüssig in der Leiterplatte 2 verankert. Im Anschluss daran wird das Kondensatorbauteil 3 wiederum in das Halteelement 4 eingeclipst. Hierzu wird das Kondensatorbauteil 3 im Wesentlichen parallel zur Leiterplatte 2 vorausgerichtet und soweit in den Fensterbereich 9 der Rahmenstruktur 8, unter elastischer Vorspannung der Haltenasen 7 hineingedrückt, bis die Haltenasen 7 aufgrund ihrer elastischen Kräfte das Kondensatorbauteil 3 in Richtung Leiterplatte 2 festhalten. Wenn schließlich der dickste Bereich der Mantelfläche 18 zur Leiterplatte hin an den Haltenasen 7 vorbeigeschoben ist, rasten die Haltenasen 7 hinter dem Kondensatorbauteil 3 ein und halten das Kondensatorbauteil 3 in einer vorgespannten Stellung, wobei das Kondensatorbauteil 3 zugleich an den Haltestegen 15 angedrückt wird. Im Anschluss daran wird das Gehäuse 11 fertig um den Zusammenbau zwischen Leiterplatte 2 und Kondensatorbauteil 3 (inkl. Halteelement 4) herum befestigt, sodass die Leiterplatte 2 verschiebefest in dem Gehäuse 11 aufgenommen ist. Bei diesem Schritt wird dabei vorzugsweise auch die wärmeleitende Klebeverbindung zwischen Kondensatorbauteil 3 und Gehäuse 11 angebracht.

In anderen Worten ausgedrückt, ist in dem erfindungsgemäßen Elektronikmodul 1 ein Halteelement 4 für die Befestigung von Elektrolytkondensatoren 3 mit partieller Halterung im Bodenbereich (Befestigungselemente 23) sowie flexiblen Kliphaltern (Haltenasen 7), die das Bauteil 3 in der Halterung vorspannen, vorgesehen. Ausschnitte im Bodenbereich (Fensterbereich 9) des Halteelements 4 sind vorgesehen, um die Bauteilplatzierung auf dem PCB 2 in dem Bereich zulassen zu können. Das Halteteil / Halteelement 4 ist vorzugsweise als ein aus Kunststoff gespritztes Teil konzipiert. Der Kondensator 3 wird in dem Halteteil 4 eingeklipst und die Klipse 7 des Halteteils 4 sorgen dabei für die Vorspannung zwischen der Klippgeometrie seitlich und den erhobenen Kontaktflächen (Auflagevorsprünge 16) auf dem Boden des Teils 4. Somit ist der Elektrolytkondensator 3 vibrationsfest gehalten. Das Halteteil 4 an sich ist durch Pins 23 in der PCB 2 in x/y Richtung (in der Ebene der PCB 2) befestigt und in der axialen z- Richtung durch die Klebung zwischen Elektrolytkondensator 3 und Wärmesenke mit einem Wärmeleitkleber gehalten. Der Wärmeleitkleber ist bei entsprechender Verlustleistung auf dem Elektrolytkondensator 3 insbesondere sinnvoll, um die Robustheit hinsichtlich elektrischer Funktion über zahlreiche Langzeitbelastungen hinweg garantieren zu können. Mit dieser Art der Anbindung garantiert man die Robustheit des Bauteils 3 gegenüber Vibrationen. Alternativ kann man auch die Haltepins 23 zur PCB 2 als Kliphalter mit Hinterschnitt ausführen, wodurch auch auf die Klebung verzichtet werden kann.

### Bezugszeichenliste

- 1: Elektronikmodul
- 2: Leiterplatte
- 3: elektronisches Bauteil / Kondensatorbauteil
- 4: Halteelement
- 5: Aufnahmeraum
- 6: Oberfläche
- 7: Haltenase
- 8: Rahmenstruktur
- 9: Fensterbereich
- 10: Stützfuß
- 11: Gehäuse
- 12: Verbindungsleitung
- 13: Unterseite des Kondensatorbauteils
- 14: Längsseite
- 15: Haltesteg
- 16: Auflagevorsprung
- 17: Querseite
- 18: Mantelfläche
- 19: Stirnseite
- 20: Unterseite des Halteelementes
- 21: Unterkante
- 22: Auflageebene
- 23: Befestigungselement
- 24: Oberseite des Kondensatorbauteils
- 25: Längsachse

## Patentansprüche

1. Elektronikmodul (1) für einen in einem Kraftfahrzeug verwendbaren Aktor, mit einer Leiterplatte (2) sowie zumindest einem auf der Leiterplatte (2) angeordneten elektronischen Bauteil (3), wobei das elektronische Bauteil (3) mittels eines Halteelementes (4) so beabstandet zu einer Oberfläche (6) der Leiterplatte gehalten ist, dass ein Aufnahmeraum (5) zwischen dem elektronischen Bauteil (3) und der Leiterplatte (2) ausgebildet ist, und wobei das Elektronikmodul (1) ein Gehäuse (11) aufweist, in dem die Leiterplatte (2) aufgenommen ist, **dadurch gekennzeichnet, dass** das elektronische Bauteil (3) über eine wärmeleitende Klebeverbindung mit dem Gehäuse (11) des Elektronikmoduls (1) verbunden ist, und das elektronische Bauteil ein Elektrolytkondensator (3) ist, der in einer von der Leiterplatte (2) abgewandten Oberseite (24) eine Wärmesenke aufweist und diese Wärmesenke über den Wärmekleber mit dem Gehäuse (11) verbunden ist.

2. Elektronikmodul (1) nach Anspruch 1, **dadurch gekennzeichnet, dass** das elektronische Bauteil (3) eine längliche Form aufweist und liegend zur Leiterplatte (2) angebracht ist.

3. Elektronikmodul (1) nach einem der Ansprüche 1 oder 2, **dadurch gekennzeichnet, dass** das elektronische Bauteil (3) formschlüssig an dem Halteelement (4) angebracht ist.

4. Elektronikmodul (1) nach einem der Ansprüche 1 bis 3, **dadurch gekennzeichnet, dass** das elektronische Bauteil (3) über an dem Halteelement (4) angebrachte vorspannbare Haltenasen (7) gehalten ist.

5. Elektronikmodul (1) nach einem der Ansprüche 1 bis 4, **dadurch gekennzeichnet, dass** das elektronische Bauteil (3) spielfrei in dem Halteelement (4) eingespannt ist.

6. Elektronikmodul (1) nach einem der Ansprüche 1 bis 5, **dadurch gekennzeichnet, dass** das Haltelement (4) eine Rahmenstruktur (8) aufweist, die einen Fensterbereich (9) einschließt, in dem das elektronische Bauteil (3) zumindest teilweise angeordnet ist.

7. Elektronikmodul (1) nach einem der Ansprüche 1 bis 6, **dadurch gekennzeichnet, dass** das Haltelement (4) zumindest einen Stützfuß (10) aufweist, mit dem es in der Leiterplatte (2) verankert ist.

8. Aktor zum Betätigen einer Kupplung und/oder eines Getriebes eines Kraftfahrzeuges, mit einem Elektronikmodul (1) nach zumindest einem der Ansprüche 1 bis 7.

## Claims

1. An electronic module (1) for an actor usable in a motor vehicle, with a printed circuit board (2) and at least one electronic component (3) arranged on the printed circuit board (2), wherein the electronic component (3) is held by means of a holding element (4) at a distance from a surface (6) of the printed circuit board such that a holding space (5) is formed between the electronic component (3) and the printed circuit board (2), and wherein the electronic module (1) has a housing (11), in which the printed circuit board (2) is held, **characterised in that** the electronic component (3) is connected via a heat-conducting adhesive connection with the housing (11) of the electronic module (1), and the electronic component is an electrolyte capacitor (3), which has a heat sink in an upper side (24) facing away from the printed circuit board (2) and this heat sink is connected to the housing (11) via a thermal adhesive.

2. The electronic module (1) according to claim 1, **characterised in that** the electronic component (3) has an elongated form and is attached lying on the printed circuit board (2).

3. The electronic module (1) according to any one of claims 1 or 2, **characterised in that** the electronic component (3) is attached to the holding element (4) in a form-fitting manner.

4. The electronic module (1) according to any one of claims 1 to 3, **characterised in that** the electronic component (3) is held via pre-tensionable holding collars (7) attached to the holding element (4).

5. The electronic module (1) according to any one of claims 1 to 4, **characterised in that** the electronic component (3) is tensioned in the holding element (4) free of play.

6. The electronic module (1) according to any one of claims 1 to 5, **characterised in that** the holding element (4) has a frame structure (8) which encloses the one window section (9) in which the electronic component (3) is at least partially arranged.

7. The electronic module (1) according to any one of claims 1 to 6, **characterised in that** the holding element (4) has at least one supporting foot (10) with which it is anchored in the printed circuit board (2).

8. An actuator for actuating a clutch and/or a transmission of a motor vehicle, with an electronic module (1) according to at least one of claims 1 to 7.

## Revendications

1. Module électronique (1) pour un actionneur pouvant être utilisé dans un véhicule automobile, comprenant un circuit imprimé (2) ainsi qu'au moins un composant électronique (3) disposé sur le circuit imprimé (2), le composant électronique (3) étant maintenu à distance d'une surface (6) du circuit imprimé au moyen d'un élément de retenue (4) de manière à former un espace de logement (5) entre le composant électronique (3) et le circuit imprimé (2) et le module électronique (1) comportant un boîtier (11), dans lequel est logé le circuit imprimé (2), **caractérisé en ce que** le composant électronique (3) est relié au boîtier (11) du module électronique (1) par une liaison adhésive thermoconductrice et le composant électronique est un condensateur électrolytique (3) qui comporte sur un côté supérieur (24) opposé au circuit imprimé (2) un dissipateur thermique et ce dissipateur thermique est relié par l'adhésif thermique au boîtier (11).

2. Module électronique (1) selon la revendication 1, **caractérisé en ce que** le composant électronique (3) est de forme allongée et monté à plat sur le circuit imprimé (2).

3. Module électronique (1) selon l'une quelconque des revendications 1 ou 2, **caractérisé en ce que** le composant électronique (3) est monté sur l'élément de retenue (4) par complémentarité de forme.

4. Module électronique (1) selon l'une quelconque des revendications 1 à 3, **caractérisé en ce que** le composant électronique (3) est retenu par un crochet de retenue (7) pouvant être précontraint monté sur l'élément de retenue (4).

5. Module électronique (1) selon l'une quelconque des revendications 1 à 4, **caractérisé en ce que** le composant électronique (3) est serré sans jeu dans l'élément de retenue (4).

6. Module électronique (1) selon l'une quelconque des revendications 1 à 5, **caractérisé en ce que** l'élément de retenue (4) comporte une armature (8) qui renferme une zone fenêtre (9) dans laquelle le composant électronique (3) est disposé au moins partiellement.

7. Module électronique (1) selon l'une quelconque des revendications 1 à 6, **caractérisé en ce que** l'élément de retenue (4) comporte un pied support (10) avec lequel il est ancré dans le circuit imprimé (2).

8. Actionneur pour actionner un embrayage et/ou une boîte de vitesses d'un véhicule automobile, comprenant un module électronique (1) selon au moins l'une quelconque des revendications 1 à 7.
